# EUROPEAN PATENT SPECIFICATION

(11) **EP 4 436 323 B1**
(45) Date of publication and mention of the grant of the patent: **08.10.2025**
(21) Application number: 22925104.6
(22) Date of filing: 02.12.2022
(51) Int. Cl.: C23C 28/02, C23C 30/00, C25D 5/02, C25D 11/04, C25D 11/26, C25D 11/30, C25D 11/34, C25D 7/00, H05K 5/00, H05K 5/04

(54) **ELECTRONIC DEVICE HOUSING AND ELECTRONIC DEVICE COMPRISING SAME**
GEHÄUSE FÜR ELEKTRONISCHE VORRICHTUNG UND ELEKTRONISCHE VORRICHTUNG DAMIT
BOÎTIER DE DISPOSITIF ÉLECTRONIQUE ET DISPOSITIF ÉLECTRONIQUE LE COMPRENANT

(30) Priority: 04.02.2022 KR 20220014933; 23.03.2022 KR 20220036091
(43) Date of publication of application: 25.09.2024
(73) Proprietor: Samsung Electronics Co., Ltd., Suwon-si, Gyeonggi-do 16677 (KR)
(72) Inventor: LEE, Yoonhee, Suwon-si Gyeonggi-do 16677 (KR); SHIN, Juncheol, Suwon-si Gyeonggi-do 16677 (KR); KIM, Aeree, Suwon-si Gyeonggi-do 16677 (KR); PARK, Joungki, Suwon-si Gyeonggi-do 16677 (KR); BAEK, Seungchang, Suwon-si Gyeonggi-do 16677 (KR); IM, Junghyun, Suwon-si Gyeonggi-do 16677 (KR); JEONG, Jinhwan, Suwon-si Gyeonggi-do 16677 (KR); CHO, Sungho, Suwon-si Gyeonggi-do 16677 (KR); HWANG, Hangyu, Suwon-si Gyeonggi-do 16677 (KR)
(74) Representative: Gulde & Partner
(86) International application number: PCT/KR2022/019522
(87) International publication number: WO 2023/149637

(56) References cited:
- CN-A- 108 505 077
- KR-A- 20200 012 550
- KR-A- 20200 094 950
- KR-A- 20200 094 950
- KR-A- 20210 090 485
- KR-A- 20210 158 220
- US-B2- 9 974 199

## Description

### TECHNICAL FIELD

Various embodiments of the present disclosure relate to an electronic device housing and an electronic device including the same.

### BACKGROUND ART

An electronic device may include a device that performs a specific function according to a loaded program, such as a home appliance, an electronic notepad, a portable multimedia player, a mobile communication terminal, a tablet personal computer (PC), a video/audio device, a desktop/laptop computer, or a vehicle navigation system. For example, such electronic devices may output stored information as sound or images. Along with an increase in the integration level of electronic devices and the increasing popularity of ultra-high-speed, large-capacity wireless communication, various functions have recently been loaded in a single electronic device, such as a mobile communication terminal. For example, an entertainment function such as gaming, a multimedia function such as music/video play, a communication and security function for mobile banking, or a scheduling function, or an electronic wallet function as well as a communication function have been integrated in a single electronic device.

An electronic device includes a housing formed of various materials, and the housing of the electronic device may protect internal components of the electronic device from external impact. The housing of the electronic device may be manufactured such that the electronic device is easy for a user to carry and to provide the user with a good appearance when used.

KR 20200094950 A discloses electronic device comprising: a housing including a front plate including a first plane part facing a first direction, a rear plate including a second plane part facing a second direction opposite to the first direction, and a side member surrounding a space between the front plate and the rear plate; a display disposed in the space to be viewed through the front plate; and a printed circuit board which is disposed in the space and includes the processor. The side member comprises: an external member including a first metal material, and including a first surface forming a surface of the side member and a second surface facing a direction of the space when viewed from above the front plate; an internal member including a second metal material, and including a third surface making contact with the second surface and a fourth surface facing the space direction, and surrounded by the external member when viewed from above the front plate; and a polymer member including a polymer material and having at least a portion surrounded by the internal member when viewed from above the front plate. Each of the second and the third surface is substantially formed in the form of a flat surface.

CN 108505077 A discloses a surface treatment method of Al-alloy parts. The method includes: the surface of Al-alloy parts is processed by shot blasting; pre-treatment is carried out to the Al-alloy parts after polishing treatment, wherein pre-treatment includes electro-galvanizing.

### DISCLOSURE OF THE INVENTION

### TECHNICAL SOLUTIONS

The present invention is defined by the appended set of claims. Preferred embodiments are defined by the dependent claims. Various processes, such as deposition or plating, may be performed to ensure the appearance quality of electronic device housings. A deposition layer formed on a surface of a housing is uniformly thin and light regardless of the shape of the deposition layer, but if peeled off, the housing may be corroded. When a plating process is performed on the surface of the housing, the total weight of a product may significantly increase because a somewhat heavy metal is used. In addition, in the case of plating, a thick plating layer may be formed in a place where currents are collected for each part of the housing, which may affect shape matching properties during assembling with other instruments.

Various embodiments according to the present invention provide an electronic device housing to which multiple surface treatments are applied and in which an oxide film, a plating layer, and a deposition layer are formed through anodizing, to realize a high gloss exterior surface and simultaneously reduce a weight gain.

However, goals to be achieved are not limited to those described above, and other goals not mentioned above can be clearly understood by one of ordinary skill in the art from the following description.

An electronic device housing according to the present invention includes a metal substrate, a plastic injection part formed on a first area of a surface of the metal substrate, an oxide film layer formed on a second area of the surface of the metal substrate, a plating layer formed on a third area of the surface of the metal substrate, and a deposition layer formed on the plating layer, wherein the oxide film layer and the plating layer are formed to be spaced apart from each other.

An electronic device housing according to various embodiments includes a metal substrate formed by bonding a first metal portion and a second metal portion, a plastic injection part formed on a first area of a surface of the metal substrate, an oxide film layer formed on a second area of the surface of the metal substrate, a plating layer formed on a third area of the surface of the metal substrate, and a deposition layer formed on the plating layer, wherein the first area includes at least a portion of a bounding portion between the first metal portion and the second metal portion, the oxide film layer and the plating layer are formed to be spaced apart from each other, and each of the first metal portion and the second metal portion includes at least one of Al, Ti, Mg, and Zn.

An electronic device according to various embodiments includes an electronic device housing, wherein the electronic device housing includes a metal substrate, a plastic injection part formed on a first area of a surface of the metal substrate, an oxide film layer formed on a second area of the surface of the metal substrate, a plating layer formed on a third area of the surface of the metal substrate, and a deposition formed on the plating layer, wherein the oxide film layer and the plating layer are formed to be spaced apart from each other.

### EFFECTS OF THE INVENTION

An electronic device housing according to various embodiments, in which an oxide film layer and a plating layer formed together on a metal substrate and which has a metal texture realized with a high brightness and high gloss while reducing a weight gain, may be provided. According to various embodiments, a plastic injection part may be formed on the metal substrate, and accordingly, it is possible to prevent and reduce appearance defects due to peeling of the coating that occurs during a process.

### BRIEF DESCRIPTION OF DRAWINGS

FIG. 1 is a perspective view illustrating a front surface of a mobile electronic device according to various embodiments.
FIG. 2 is a perspective view of a rear surface of the electronic device of FIG. 1.
FIG. 3 is an exploded perspective view of the electronic device of FIG. 1.
FIG. 4 is a diagram illustrating a top surface of an electronic device housing according to various embodiments.
FIG. 5 is a cross-sectional perspective view of an electronic device housing according to various embodiments.
FIG. 6 is a cross-sectional view of an electronic device housing according to various embodiments.
FIG. 7 is a cross-sectional view of an electronic device housing according to various embodiments.
FIG. 8 is a flowchart illustrating a process of an electronic device housing according to various embodiments.

### BEST MODE FOR CARRYING OUT THE INVENTION

Hereinafter, various embodiments of the present disclosure will be described in detail with reference to the accompanying drawings.

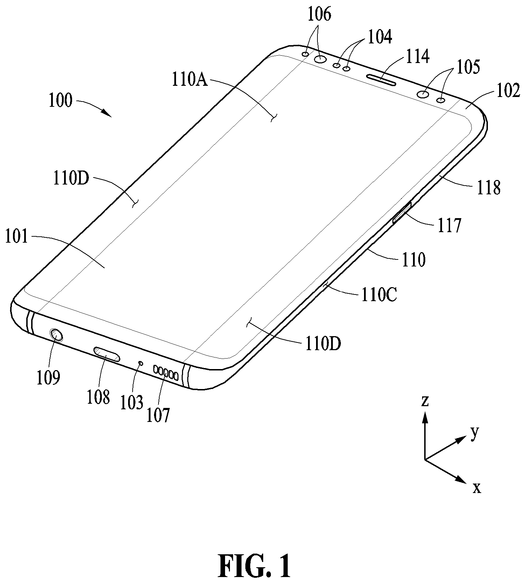

FIG. 1 is a perspective view illustrating a front surface of a mobile electronic device 100 according to various embodiments.

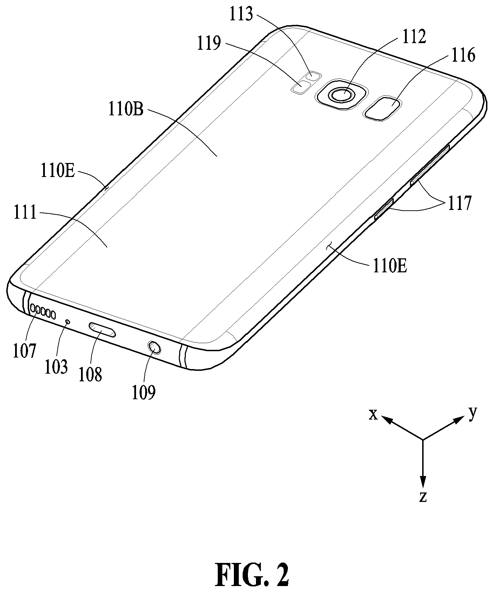

FIG. 2 is a perspective view of a rear surface of the electronic device 100 of FIG. 1.

Referring to FIGS. 1 and 2, an electronic device 100 according to various embodiments may include a housing 110 including a first face (or a front face) 110A, a second face (or a rear face) 110B, and a side face 110C surrounding a space between the first face 110A and the second face 110B. In another embodiment (not shown), the housing may also refer to a structure that forms a portion of the first face 110A, the second face 110B, and the side face 110C of FIG. 1. According to various embodiments, the first surface 110A may be formed by a front plate 102 (e.g., a polymer plate or a glass plate including various coating layers) which is at least partially transparent. The second surface 110B may be formed of a rear plate 111 that is substantially opaque. For example, the rear plate 111 may be formed of coated or colored glass, ceramic, polymer, metal materials (e.g., aluminum, stainless steel (STS), or magnesium) or a combination of at least two of the above materials. The side surface 110C may be coupled to the front plate 102 and the rear plate 111 and may be formed by a side bezel structure (or a side member) 118 including metal and/or polymer. In some embodiments, the rear plate 111 and the side bezel structure 118 may be formed integrally and may include the same material (e.g., a metal material such as aluminum).

In the illustrated embodiment, the front plate 102 may include two first regions 110D seamlessly extended by being bent from the first face 110A toward the rear plate 111 at both ends of a long edge of the front plate 102. In the illustrated embodiment (see FIG. 2), the rear plate 111 may include two second regions 110E seamlessly extended by being bent from the second face 110B toward the front plate 102 at both ends of a long edge. In some embodiments, the front plate 102 (or the rear plate 111) may include one of the first regions 110D (or the second regions 110E). In another embodiment, some of the first regions 110D or the second region 110E may not be included. In the above embodiments, in a side view of the electronic device 100, the side bezel structure 118 may have a first thickness (or width) at a side in which the first regions 110D or the second regions 110E are not included, and may have a second thickness less than the first thickness at a side in which the first regions 110D or the second regions 110E are included.

According to various embodiments, the electronic device 100 may include at least one of a display 101, audio modules 103, 107, and 114, sensor modules 104, 116, and 119, camera modules 105, 112, and 113, a key input device 117, a light emitting element 106, and connector holes 108 and 109. In some embodiments, the electronic device 100 may not include at least one of components (e.g., the key input device 117 or the light emitting element 106) or additionally include other components.

The display 101 may be exposed through, for example, some portions of the front plate 102. In some embodiments, at least a portion of the display 101 may be exposed through the first face 110A and the front plate 102 constructing the first regions 110D of the side face 110C. In some embodiments, edges of the display 101 may be formed to be substantially the same as the shape of the periphery of the front plate 102 adjacent thereto. In another embodiment (not shown), the distance between the periphery of the display 101 and the periphery of the front plate 102 may be substantially constant in order to enlarge the exposed area of the display 101.

In another embodiment (not shown), a recess or an opening may be formed in a portion of a screen display region of the display 101, and at least one of the audio module 114, the sensor module 104, and the camera module 105, and the light emitting element 106 that are aligned with the recess or the opening may be included. In another embodiment (not shown), a rear face of the screen display region of the display 101 may include at least one of the audio module 114, the sensor module 104, the camera module 105, the fingerprint sensor module 116, and the light emitting element 106. In another embodiment (not shown), the display 101 may be coupled to or arranged adjacent to a touch sensing circuit, a pressure sensor for measuring an intensity (pressure) of a touch, and/or a digitizer for detecting a magnetic-type stylus pen. In some embodiments, at least a portion of the sensor modules 104 and 119, and/or at least a portion of the key input device 117 may be disposed in the first regions 110D and/or the second regions 110E.

The audio modules 103, 107, and 114 may include a microphone hole 103 and speaker holes 107 and 114. A microphone for acquiring external sound may be disposed in the microphone hole 103. In some embodiments, a plurality of microphones may be disposed to detect a direction of sound. The speaker holes 107 and 114 may include an external speaker hole 107 and a receiver hole 114 for a call. In some embodiments, the speaker holes 107 and 114 and the microphone hole 103 may be implemented as one hole, or a speaker (e.g., a Piezo speaker) may be included without the speaker holes 107 and 114.

The sensor modules 104, 116, and 119 may generate an electrical signal or a data value corresponding to an internal operating state of the electronic device 100 or an external environmental state. The sensor modules 104, 116, and 119 may include, for example, the first sensor module 104 (e.g., a proximity sensor) and/or second sensor module (not shown) (e.g., a fingerprint sensor) disposed on the first face 110A of the housing 110, and/or the third sensor module 119 (e.g., a heart rate monitoring (HRM) sensor) disposed on the second face 110B of the housing 110 and/or the fourth sensor module 116 (e.g., a fingerprint sensor). The fingerprint sensor may be disposed on both the first face 110A (e.g., the display 101) and the second face 110B of the housing 110. The electronic device 100 may further include at least one of sensor modules (not shown), for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, and an illuminance sensor 104.

The camera modules 105, 112, and 113 may include a first camera module 105 disposed on the first face 110A of the electronic device 100, a second camera module 112 disposed on the second face 110B, and/or a flash 113. The camera modules 105 and 112 may each include one or more lenses, an image sensor, and/or an image signal processor. The flash 113 may include, for example, a light-emitting diode (LED) or a xenon lamp. In some embodiments, two or more lenses (IR cameras, wide angle and telephoto lenses) and image sensors may be disposed on one face of the electronic device 100.

The key input device 117 may be disposed on the side surface 110C of the housing 110. In another embodiment, the electronic device 100 may not include some or all of the above-described key input device 117. The key input device 117 that is not included may be implemented in another form such as a soft key on the display 101. In some embodiments, the key input device may include the sensor module 116 disposed on the second face 110B of the housing 110.

The light emitting element 106 may be disposed on, for example, the first face 110A of the housing 110. The light emitting element 106 may provide, for example, state information of the electronic device 100 in a form of light. In another embodiment, the light emitting element 106 may provide, for example, a light source that is linked to the operation of the camera module 105. The light emitting element 106 may include, for example, an LED, an IR LED, and a xenon lamp.

The connector holes 108 and 109 may include a first connector hole 108 for accommodating a connector (e.g., a universal serial bus (USB) connector) for transmitting and receiving power and/or data to and from an external electronic device, and/or a second connector hole 109 (e.g., an earphone jack) for accommodating a connector for transmitting and receiving an audio signal to and from an external electronic device.

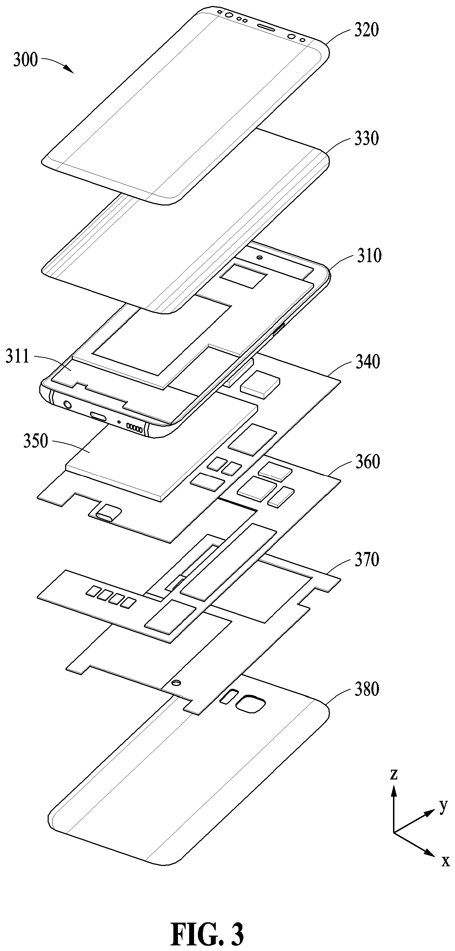

FIG. 3 is an exploded perspective view of the electronic device of FIG. 1.

Referring to FIG. 3, an electronic device 300 may include a side bezel structure 310, a first support member 311 (e.g., a bracket), a front plate 320, a display 330, a printed circuit board (PCB) 340, a battery 350, a second support member 360 (e.g., a rear case), an antenna 370, and a rear plate 380. In some embodiments, the electronic device 300 may omit at least one (e.g., the first support member 311 or the second support member 360) of the components, or may additionally include other components. At least one of the components of the electronic device 300 may be the same as or similar to at least one of the components of the electronic device 100 of FIG. 1 or 2, and a repeated description thereof will be omitted here.

The first support member 311 may be disposed inside the electronic device 300 and connected to the side bezel structure 310, or formed integrally with the side bezel structure 310. The first support member 311 may be formed of, for example, a metal material and/or a non-metal material (e.g., polymer). The display 330 may be connected to one surface of the first support member 311, and the PCB 340 may be connected to another surface of the first support member 311. A processor, a memory, and/or an interface may be mounted on the PCB 340. The processor may include, for example, one or more of a central processing unit, an application processor, a graphic processing unit, an image signal processor, a sensor hub processor, and a communication processor.

The memory may include, for example, a volatile memory or a non-volatile memory.

The interface may include, for example, a high-definition multimedia interface (HDMI), a USB interface, a secure digital (SD) card interface, or an audio interface. For example, the interface may electrically or physically connect the electronic device 300 to an external electronic device, and may include a USB connector, an SD card/multimedia card (MMC) connector, or an audio connector.

The battery 350 may be a device for supplying power to at least one component of the electronic device 300, and may include, for example, a primary cell which is not rechargeable, a rechargeable secondary cell, or a fuel cell. For example, at least a portion of the battery 350 may be disposed on substantially the same plane as the PCB 340. The battery 350 may be disposed integrally inside the electronic device 300, or disposed detachably from the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or may wirelessly transmit and receive power required for charging to and from the external device. In another embodiment, an antenna structure may be formed by a portion of the side bezel structure 310 and/or the first support member 311 or a combination thereof.

Hereinafter, the housing 110 forming an external appearance of the electronic device 100 will be further described through various embodiments.

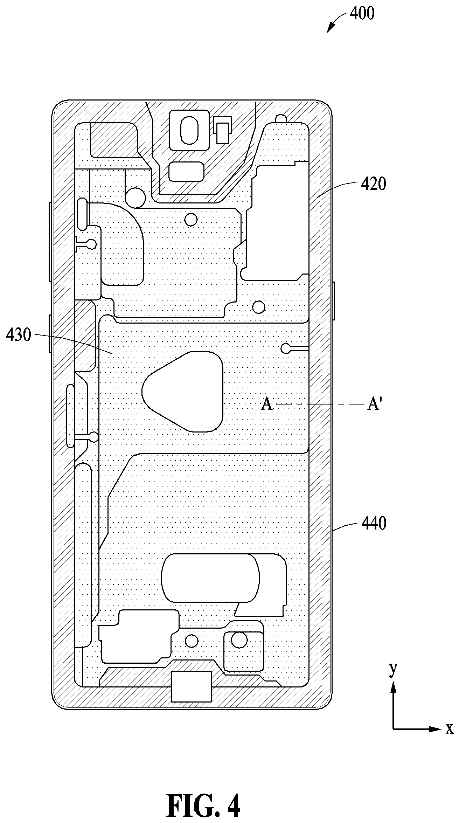

FIG. 4 is a diagram illustrating a top surface of an electronic device housing 400 according to various embodiments.

According to various embodiments, it may be confirmed that the electronic device housing 400 includes a plastic injection part 420, an oxide film layer 430, and a plating layer 440 formed on a surface thereof. Here, a deposition layer (not shown) may be further formed on the plating layer 440. According to various embodiments, the plastic injection part 420 may be formed in a hollow structure with a band shape to allow the oxide film layer 430 and plating layer 440 to be spaced apart from each other.

According to various embodiments, the electronic device housing 400 may be applied to a housing (the housing 110 of FIG. 1) of an electronic device (the electronic device 100 of FIG. 1). According to various embodiments, the electronic device housing 400 may be applied to a support member (e.g., the first support member 311 and the second support member 360 of FIG. 3) of an electronic device (the electronic device 300 of FIG. 3).

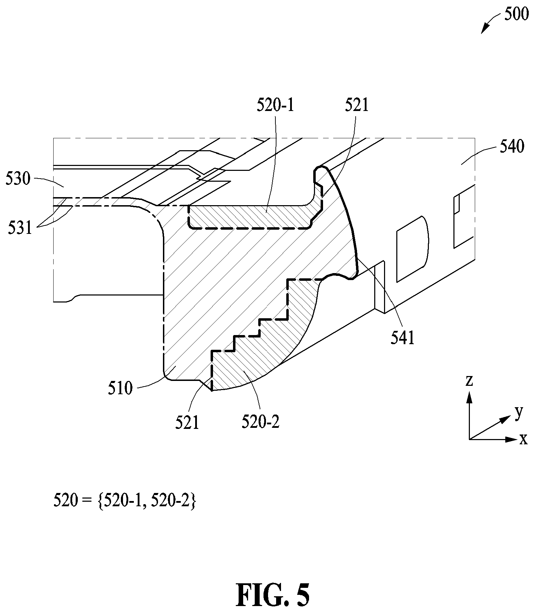

FIG. 5 is a cross-sectional perspective view of an electronic device housing 500 according to various embodiments.

FIG. 5 corresponds to a cross section of the electronic device housing 400 taken along line A-A' of FIG. 4. According to various embodiments, at least another portion (e.g., a portion used as an antenna radiator) of the electronic device housing 400 may not include a plastic injection part.

Referring to FIG. 5, the electronic device housing 500 may include a metal substrate 510, a plastic injection part 520 formed on a first area 521 of a surface of the metal substrate 510, an oxide film layer 530 formed on a second area 531 of the surface of the metal substrate 510, and a plating layer 540 formed on a third area 541 of the surface of the metal substrate 510. According to various embodiments, a deposition layer (not shown) may be formed on the plating layer 540. For convenience of description, in FIG. 5, a +X direction is assumed as a direction toward the outside of the electronic device 100 and a -X direction is assumed as a direction toward the inside of the electronic device 100. According to various embodiments, the third area 541 may include an antenna structure. According to various embodiments, the third area 541 may include a segmentation portion to form an antenna structure. For example, at least a portion of the third area 541 may be used as an antenna radiator.

According to various embodiments, the metal substrate 510 may include at least one of Al, Ti, Mg, and Zn. For example, the metal substrate 510 may include aluminum and may be an aluminum alloy. Specifically, for example, the metal substrate 510 may include, as an aluminum alloy, one selected from a 1000 series aluminum alloy, a 5000 series aluminum alloy (Al-Mg series aluminum alloy), a 6000 series aluminum alloy (Al-Mg-Si series aluminum alloy), a 7000 series aluminum alloy (Al-Zn-Mg series aluminum alloy), and a combination thereof.

According to various embodiments, the metal substrate 510 may include at least one of an extruded material, a rolled material, and a casting material. According to various embodiments, the metal substrate 510 may be an alloy of various metals and may be suitable to be applied to various electronic devices due to an excellent rigidity thereof.

According to various embodiments, the plastic injection part 520 may be formed on at least a portion of the surface of the metal substrate 510. For example, the plastic injection part 520 may be formed on the first area 521 of the surface of the metal substrate 510. Here, the first area 521 may be a collection of areas including two or more areas separately disposed.

Referring to FIG. 5, a plastic injection part 520-1 may be formed on at least one area (e.g., the first area 521) of a +Z directional face of the surface of the metal substrate 510, and a plastic injection part 521-2 may be formed at least one area of a -Z directional face of the surface of the metal substrate 510. Desirably, the plastic injection parts 520-1 and 520-2 may be formed on at least two faces (e.g., faces facing each other on the first area 521) of the surface of the metal substrate 510.

According to various embodiments, at least a portion of a cross section of the plastic injection part 520-1, 520-2 on the surface of the metal substrate 510 may have an angled shape. For example, at least a portion of the cross section of the plastic injection part 520-1, 520-2 may have a staircase shape, a zigzag shape, and/or a sawtooth shape.

According to the invention, the oxide film layer 530 is formed on the second area 531 of the surface of the metal substrate 510, and the plating layer 540 is formed on the third area 541 of the surface of the metal substrate 510. According to the invention, the second area 531 and the third area 541 are portions of the surface of the metal substrate 510 spaced apart from each other with the first area 521 therebetween, and accordingly, the oxide film layer 530 and the plating layer 540 are formed to be spaced apart from each other. For example, the oxide film layer 530 may be disposed in the -X direction with respect to the plastic injection part 520, and the plating layer 540 may be disposed in the +X direction with respect to the plastic injection part 520. Desirably, the plating layer 540 may be disposed on the outside of the electronic device housing 500, because the electronic device housing 500 has a high gloss appearance due to the plating layer 540.

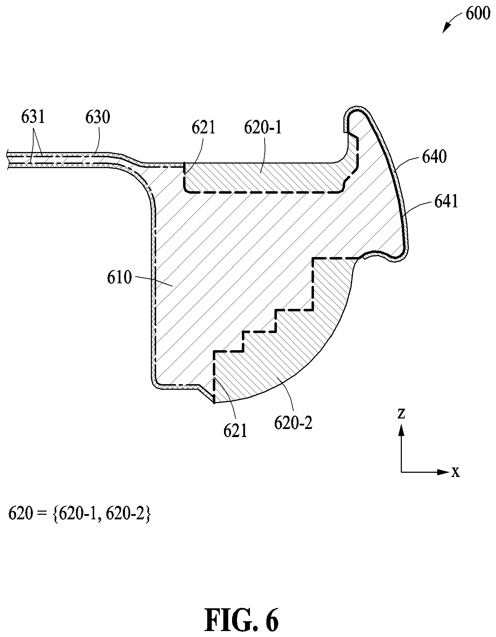

FIG. 6 is a cross-sectional view of an electronic device housing 600 according to various embodiments.

Referring to FIG. 6, the electronic device housing 600 may include a metal substrate 610 (the metal substrate 510 of FIG. 5), a plastic injection part 620={620-1, 620-2} (the plastic injection part 520={520-1, 520-2} of FIG. 5) formed on a first area 621 (the first area 521 of FIG. 5) of a surface of the metal substrate 610, an oxide film layer 630 (the oxide film layer 530 of FIG. 5) formed on a second area 631 (the second area 531 of FIG. 5) of the surface of the metal substrate 610, and a plating layer 640 (the plating layer 540 of FIG. 5) formed on a third area 641 (the third area 541 of FIG. 5) of the surface of the metal substrate 610. According to various embodiments, a deposition layer (not shown) may be formed on the plating layer 640. According to various embodiments, the third area 641 may include an antenna structure. According to various embodiments, the third area 641 may include a segmentation portion to form an antenna structure. For example, at least a portion of the third area 641 may be used as an antenna radiator.

According to various embodiments, the metal substrate 610 may include at least one of Al, Ti, Mg, and Zn. For example, the metal substrate 610 may include aluminum and may be an aluminum alloy. Specifically, for example, the metal substrate 610 may include, as an aluminum alloy, one selected from a 1000 series aluminum alloy, a 5000 series aluminum alloy (Al-Mg series aluminum alloy), a 6000 series aluminum alloy (Al-Mg-Si series aluminum alloy), a 7000 series aluminum alloy (Al-Zn-Mg series aluminum alloy), and a combination thereof.

According to various embodiments, the metal substrate 610 may include at least one of an extruded material, a rolled material, and a casting material. According to various embodiments, the metal substrate 610 may be an alloy of various metals and may be suitable to be applied to various electronic devices due to an excellent rigidity thereof.

According to various embodiments, based on a cross section of the metal substrate 610, the plating layer 640 may be formed on a partial area of the surface of the metal substrate 610 in the +X direction with respect to the plastic injection part 620, and the oxide film layer 630 may be formed on a partial area of the surface of the metal substrate 610 in the -X direction with respect to the plastic injection part 620. Accordingly, a portion of an appearance of an electronic device (the electronic device 100 of FIG. 1, and the electronic device 300 of FIG. 3) that is relatively easily visible may have high gloss characteristics. According to various embodiments, the oxide film layer 630 and the plating layer 640 may be formed to be spaced apart from each other, and the plastic injection part 620 may be disposed therebetween. According to various embodiments, the plastic injection part 620 may be formed on a partial area of the surface of the metal substrate 610 such that the oxide film layer 630 may substantially not contact the plating layer 640 and/or the deposition layer, and thus, it is possible to prevent an occurrence of a phenomenon, such as peeling of the coating during a process such as a plating process.

According to various embodiments, the plastic injection part 620 may be formed in a hollow structure. According to various embodiments, when the electronic device housing 600 is viewed in the -Z direction on a +Z axis and viewed in the +Z direction on a -Z axis, the plastic injection part 620 may form a band shape, such as "o" or "□" but the shape of the plastic injection part 620, such as "∘" or "□," is merely an example and it is obvious to one of ordinary skill in the art that various hollow structures may be formed. According to various embodiments, the plating layer 640 and the deposition layer may be formed on a surface of the electronic device housing 600 that relatively forms an exterior of the electronic device, the oxide film layer 630 may be formed on a surface of the electronic device housing 600 that relatively forms an interior of the electronic device, and the plastic injection part 620 may be formed between the oxide film layer 630 and the plating layer 640 and/or the deposition layer to substantially separate the oxide film layer 630 from the plating layer 640 and/or the deposition layer and to substantially prevent a contact between the oxide film layer 630 and the plating layer 640 and/or the deposition layer.

According to various embodiments, the plastic injection part 620 may include an engineering plastic. According to various embodiments, the plastic injection part 620 may be a non-conductive engineering plastic and may include at least one of polycarbonate (PC), acrylonitrile butadiene styrene (ABS), polyphenylene sulfide (PPS), polyimide (PI), polyoxymethylene (POM), polyphenylene oxide (PPO), polybutylene terephthalate (PBT), polyether ether ketone (PEEK), polyaryletherketone (PAEK), polyamide (PA), and polyphthalamide (PPA). The engineering plastic may be a plastic with a high strength and a heat resistance to 100°C or higher, and may be excellent in impact resistance, wear resistance, cold resistance, chemical resistance, electrical insulation, and the like. However, the type of plastics that may be included in the plastic injection part 620 is not limited thereto.

According to various embodiments, the plastic injection part 620 may further include at least one inorganic material among a glass fiber, a carbon fiber, and talc. According to various embodiments, an inorganic material may be further included in the plastic injection part 620, and thus, heat resistance, strength, impact resistance, and/or wear resistance may be enhanced. According to various embodiments, a weight ratio of the engineering plastic and the inorganic material included in the plastic injection part 620 may be in a range of 50 : 50 to 99 : 1.

According to various embodiments, the oxide film layer 630 may be non-conductive. According to various embodiments, since the oxide layer 630 is non-conductive, a plating process may not be performed. According to various embodiments, the oxide film layer 630 may be formed through a process of anodizing the metal substrate 610 in which the plastic injection part 620 is formed. Specifically, the oxide film layer 630 may be formed by immersing the metal substrate 610 in an anodizing solution containing sulfuric acid. Here, the anodizing solution may further include at least one of hydrochloric acid, phosphoric acid, nitric acid, oxalic acid, chromic acid, sulfamic acid, maronic acid, sodium hydroxide, sodium sulfate, ammonium bifluoride, hydrofluoric acid, sodium fluoride, potassium fluoride, ammonium fluoride, and triazine thiol.

According to various embodiments, an additional coating layer (not shown) may be formed on the oxide film layer 630 to protect this. According to various embodiments, the coating layer may impart functionalities to the electronic device housing 600, and may assign, for example, at least one of an antistatic effect, anti-fingerprint effect, an anti-fouling effect, an anti-scratch effect, a low refraction, an anti-reflection effect, and/or a shock absorption effect. According to various embodiments, the coating layer may be implemented by schemes, such as painting, electrodeposition, printing, or film coating, however, embodiments are not limited thereto.

According to various embodiments, the plating layer 640 may include at least one of Cu, Ni, Cr, Zn, Sn, Cu-Sn, Cu-Sn-Zn, Au, and Pt. According to various embodiments, the plating layer 640 may include a plurality of plating layers. According to various embodiments, each of the plurality of plating layers may include at least one of Cu, Ni, Cr, Zn, Sn, Cu-Sn, Cu-Sn-Zn, Au, and Pt.

According to various embodiments, the plating layer 640 may be formed on the second area of the surface of the metal substrate 610, and the plating layer 640 may hide surface material defects of the metal substrate 610, may be excellent in adhesion and/or wear resistance, and may be colored and/or glossy. In addition, the plating layer 640 may be formed to fill defects such as fine pores of the metal substrate 610, and may include a metal having excellent leveling characteristics. According to various embodiments, the plating layer 640 may include a plurality of plating layers, and the respective plating layers may have different purposes. For example, a plating layer formed on the metal substrate 610 may include a metal, such as Cu, to hide surface material defects of the metal substrate 610, a plating layer that may be excellent in adhesion to the metal substrate 610 and that is disposed in the middle among plating layers 640 may include a metal, such as Cu-Sn, Cu-Sn-Zn, Ni, Ni alloy, to be colored and/or glossy, and a plating layer that may be excellent in wear resistance and that is disposed at an end of the plating layers 640 may include a noble metal (e.g., Cr, Au, and Pt) to achieve a high appearance quality. According to various embodiments, the plating layer 640 may include at least three plating layers.

According to various embodiments, the deposition layer may include at least one of Al, Ti, Cr, Zr, Au, Cu, Si, Ru, Rh, Pt, W, Pd, oxides, nitrides, and carbides thereof. According to various embodiments, the deposition layer may include a plurality of deposition layers. According to various embodiments, each of the plurality of deposition layers may include at least one of Al, Ti, Cr, Zr, Au, Cu, Si, Ru, Rh, Pt, W, Pd, oxides, nitrides, and carbides thereof.

According to various embodiments, the deposition layer may be formed on the plating layer 640, and the deposition layer may secure an adhesion to the plating layer 640 and may be excellent in corrosion resistance, hardness, wear resistance, and decorativeness. According to various embodiments, the deposition layer may exhibit various appearance qualities such as a gloss, texture, and surface shape of the metal substrate 610 and/or the plating layer 640. According to various embodiments, the deposition layer may include a plurality of deposition layers, and the respective deposition layers may have different purposes. For example, a deposition layer formed on the plating layer 640 may secure the adhesion to the plating layer 640 and may be excellent in corrosion resistance and a deposition layer disposed in the middle among the deposition layers may be excellent in hardness and wear resistance, and a deposition layer disposed on an end of the deposition layers may secure decorativeness and wear resistance. According to various embodiments, the deposition layer may include at least three deposition layers.

According to various embodiments, the plating layer 640 may have a thickness of 0.5 µm to 500 µm. According to various embodiments, the deposition layer may have a thickness of 0.1 µm to 50 µm. According to various embodiments, a ratio between the thickness of the plating layer 640 and the thickness of the deposition layer may be in a range of 5 : 1 to 100 : 1, and the deposition layer may desirably be thinner than the plating layer 640. According to various embodiments, the thickness of the plating layer 640 may be 5 times or less, 10 times or less, 15 times or less, 20 times or less, 25 times or less, 30 times or less, 35 times or less, 40 times or less, 45 times or less, 50 times or less, 55 times or less, 60 times or less, 65 times or less, 70 times or less, 75 times or less, 80 times or less, 85 times or less, 90 times or less, 95 times or less, or 100 times or less the thickness of the deposition layer.

According to various embodiments, a plastic injection part (e.g., the plastic injection part 420 of FIG. 4, the plastic injection part 520 of FIG. 5, and the plastic injection part 620 of FIG. 6) may be formed in a hollow structure.

According to various embodiments, a plating layer (e.g., the plating layer 440 of FIG. 4, the plating layer 540 of FIG. 5, and the plating layer 640 of FIG. 6) may include a plurality of plating layers.

According to various embodiments, each of the plurality of plating layers may include at least one of Cu, Ni, Cr, Zn, Sn, Cu-Sn, Cu-Sn-Zn, Au, and Pt.

According to various embodiments, a deposition layer (not shown) formed on the plating layer (e.g., the plating layer 440 of FIG. 4, the plating layer 540 of FIG. 5, and the plating layer 640 of FIG. 6) may be further included.

According to various embodiments, the deposition layer may include a plurality of deposition layers.

According to various embodiments, each of the plurality of deposition layers may include at least one of Al, Ti, Cr, Zr, Au, Cu, Si, Ru, Rh, Pt, W, Pd, oxides, nitrides, and carbides thereof.

According to various embodiments, a ratio between a thickness of the plating layer (e.g., the plating layer 440 of FIG. 4, the plating layer 540 of FIG. 5, and the plating layer 640 of FIG. 6) and a thickness of the deposition layer may be in a range of 5 : 1 to 100 : 1.

According to various embodiments, the plastic injection part (e.g., the plastic injection part 420 of FIG. 4, the plastic injection part 520 of FIG. 5, and the plastic injection part 620 of FIG. 6) may include at least one of PC, ABS, PPS, PI, POM, PPO, PBT, PEEK, PAEK, PA, and PPA.

According to various embodiments, the plastic injection part (e.g., the plastic injection part 420 of FIG. 4, the plastic injection part 520 of FIG. 5, and the plastic injection part 620 of FIG. 6) may further include at least one inorganic material among a glass fiber, a carbon fiber, and talc.

According to various embodiments, a metal substrate (e.g., the metal substrate 510 of FIG. 5, and the metal substrate 610 of FIG. 6) may include at least one of Al, Ti, Mg, and Zn.

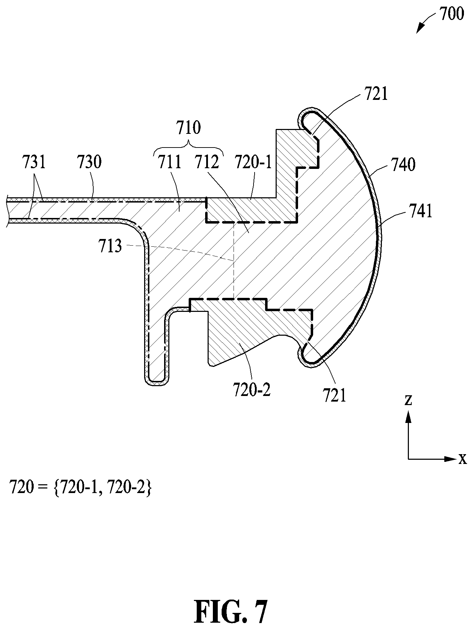

FIG. 7 is a cross-sectional view of an electronic device housing 700 according to various embodiments.

According to various embodiments, the electronic device housing 700 may include a metal substrate 710, a plastic injection part 720 (the plastic injection part 620 of FIG. 6) formed on a first area 721 of a surface of the metal substrate 710, an oxide film layer 730 (the oxide film layer 630 of FIG. 6) formed on a second area 731 of the surface of the metal substrate 710, a plating layer 740 (the plating layer 640 of FIG. 6) formed on a third area 741 of the surface of the metal substrate 710, and a deposition layer (not shown) formed on the plating layer 740. According to various embodiments, the plastic injection part 720 may be formed in a hollow structure with a band shape to allow the oxide film layer 730 and plating layer 740 to be spaced apart from each other.

According to various embodiments, the electronic device housing 700 may be applied to a housing (the housing 110 of FIG. 1) of an electronic device (the electronic device 100 of FIG. 1). According to various embodiments, the electronic device housing 700 may be applied to a support member (e.g., the first support member 311 and the second support member 360 of FIG. 3) of an electronic device (the electronic device 300 of FIG. 3).

According to various embodiments, the metal substrate 710 may include at least one of Al, Ti, Mg, and Zn. For example, the metal substrate 710 may include aluminum and may be an aluminum alloy. Specifically, for example, the metal substrate 710 may include, as an aluminum alloy, one selected from a 1000 series aluminum alloy, a 5000 series aluminum alloy (Al-Mg series aluminum alloy), a 6000 series aluminum alloy (Al-Mg-Si series aluminum alloy), a 7000 series aluminum alloy (Al-Zn-Mg series aluminum alloy), and a combination thereof.

According to various embodiments, the metal substrate 710 may include at least one of an extruded material, a rolled material, and a casting material. According to various embodiments, the metal substrate 710 may be an alloy of various metals and may be suitable to be applied to various electronic devices due to an excellent rigidity thereof.

According to various embodiments, the plastic injection part 720 may be formed on at least a portion of the surface of the metal substrate 710. For example, the plastic injection part 720 may be formed on the first area 721 of the surface of the metal substrate 710. Here, the first area 721 may be a collection of areas including two or more areas separately disposed. For example, the plastic injection part 720 may be formed on at least one area of a +Z directional face of the surface of the metal substrate 710, and a plastic injection part 720 may be formed at least one area of a -Z directional face of the surface of the metal substrate 710. Desirably, the plastic injection part 720 may be formed on at least two faces (e.g., faces facing each other on the first area 721) of the surface of the metal substrate 710.

According to various embodiments, at least a portion of a cross section of a plastic injection part 720-1, 720-2 on the surface of the metal substrate 710 may have an angled shape. For example, at least a portion of the cross section of the plastic injection part 720-1, 720-2 may have a staircase shape, a zigzag shape, and/or a sawtooth shape.

According to various embodiments, the oxide film layer 730 may be formed on the second area 731 of the surface of the metal substrate 710, and the plating layer 740 may be formed on the third area 741 of the surface of the metal substrate 710. According to various embodiments, the second area 731 and the third area 741 may be portions of the surface of the metal substrate 710 spaced apart from each other with the first area 721 therebetween, and accordingly, the oxide film layer 730 and the plating layer 740 may be formed to be spaced apart from each other. For example, the oxide film layer 730 may be disposed in the -X direction with respect to the plastic injection part 720, and the plating layer 740 may be disposed in the +X direction with respect to the plastic injection part 720. Desirably, the plating layer 740 may be disposed on the outside of the electronic device housing 700, because the electronic device housing 700 has a high gloss appearance due to the plating layer 740.

According to various embodiments, the metal substrate 710 may include a first metal portion 711 and a second metal portion 712. Referring to FIG. 7, the metal substrate 710 may be formed by bonding the first metal portion 711 that is disposed relatively in the -X direction and the second metal portion 712 that is disposed in the +X direction. Here, the first metal portion 711 and the second metal portion 712 may be bonded to form a bonding portion 713. According to various embodiments, the bonding portion 713 may be a face in contact with the first metal portion 711 and the second metal portion 712. For example, in FIG. 7, the bonding portion 713 may be formed such that a +X directional face of the first metal portion 711 and a -X directional face of the second metal portion 712 contact, however, embodiments are not limited thereto.

According to various embodiments, the metal substrate 710 may be formed by bonding an external metal frame and an internal metal shape through, for example, an insert die casting (IDC) scheme, and the like. According to various embodiments, the metal substrate 710 may be manufactured by forming the second metal portion 712 that is disposed relatively on the exterior of the electronic device and by forming the first metal portion 711 therein through casting.

According to various embodiments, the plastic injection part 720 (the plastic injection part 620 of FIG. 6) may be formed in a hollow structure. According to various embodiments, when the electronic device housing 700 is viewed in the -Z direction on a +Z axis and viewed in the +Z direction on a -Z axis, the plastic injection part 720 may form a band shape, such as "∘" or "□" but the shape of the plastic injection part 720, such as "∘" or "□," is merely an example and it is obvious to one of ordinary skill in the art that various hollow structures may be formed. According to various embodiments, the plating layer 740 (the plating layer 640 of FIG. 6) and the deposition layer (not shown) may be formed on a surface of the electronic device housing 700 that relatively forms an exterior of the electronic device, the oxide film layer 730 (the oxide film layer 630 of FIG. 6) may be formed on a surface of the electronic device housing 700 that relatively forms an interior of the electronic device, and the plastic injection part 720 may be formed between the oxide film layer 730 and the plating layer 740 and/or the deposition layer to substantially separate the oxide film layer 730 from the plating layer 740 and/or the deposition layer and to substantially prevent a contact between the oxide film layer 730 and the plating layer 740 and/or the deposition layer.

According to various embodiments, the plastic injection part 720 may include an engineering plastic. According to various embodiments, the plastic injection part 720 may be a non-conductive engineering plastic and may include at least one of polycarbonate (PC), acrylonitrile butadiene styrene (ABS), polyphenylene sulfide (PPS), polyimide (PI), polyoxymethylene (POM), polyphenylene oxide (PPO), polybutylene terephthalate (PBT), polyether ether ketone (PEEK), polyaryletherketone (PAEK), polyamide (PA), and polyphthalamide (PPA). The engineering plastic may be a plastic with a high strength and a heat resistance to 100°C or higher, and may be excellent in impact resistance, wear resistance, cold resistance, chemical resistance, electrical insulation, and the like. However, the type of plastics that may be included in the plastic injection part 720 is not limited thereto.

According to various embodiments, the plastic injection part 720 may further include at least one inorganic material among a glass fiber, a carbon fiber, and talc. According to various embodiments, an inorganic material may be further included in the plastic injection part 720, and thus, heat resistance, strength, impact resistance, and/or wear resistance may be enhanced. According to various embodiments, a weight ratio of the engineering plastic and the inorganic material included in the plastic injection part 720 may be in a range of 50 : 50 to 99 : 1.

According to various embodiments, the oxide film layer 730 (the oxide film layer 630 of FIG. 6) may be non-conductive. According to various embodiments, since the oxide layer 730 is non-conductive, a plating process may not be performed. According to various embodiments, the oxide film layer 730 may be formed through a process of anodizing the metal substrate 710 in which the plastic injection part 720 is formed. Specifically, the oxide film layer 730 may be formed by immersion in an anodizing solution containing sulfuric acid. Here, the anodizing solution may further include at least one of hydrochloric acid, phosphoric acid, nitric acid, oxalic acid, chromic acid, sulfamic acid, maronic acid, sodium hydroxide, sodium sulfate, ammonium bifluoride, hydrofluoric acid, sodium fluoride, potassium fluoride, ammonium fluoride, and triazine thiol.

According to various embodiments, an additional coating layer (not shown) may be formed on the oxide film layer 730 to protect this. According to various embodiments, the coating layer may impart functionalities to the electronic device housing 700, and may assign, for example, at least one of an antistatic effect, anti-fingerprint effect, an anti-fouling effect, an anti-scratch effect, a low refraction, an anti-reflection effect, and/or a shock absorption effect. According to various embodiments, the coating layer may be implemented by schemes, such as painting, electrodeposition, printing, or film coating, however, embodiments are not limited thereto.

According to various embodiments, the plating layer 740 (the plating layer 640 of FIG. 6) may include at least one of Cu, Ni, Cr, Zn, Sn, Cu-Sn, Cu-Sn-Zn, Au, and Pt. According to various embodiments, the plating layer 740 may include a plurality of plating layers. According to various embodiments, each of the plurality of plating layers may include at least one of Cu, Ni, Cr, Zn, Sn, Cu-Sn, Cu-Sn-Zn, Au, and Pt.

According to various embodiments, the plating layer 740 may be formed on the second area of the surface of the metal substrate 710, and the plating layer 740 may hide surface material defects of the metal substrate 710, may be excellent in adhesion and/or wear resistance, and may be colored and/or glossy. In addition, the plating layer 740 may be formed to fill defects such as fine pores of the metal substrate 710, and may include a metal having excellent leveling characteristics. According to various embodiments, the plating layer 740 may include a plurality of plating layers, and the respective plating layers may have different purposes. For example, a plating layer formed on the metal substrate 710 may include a metal, such as Cu, to hide surface material defects of the metal substrate 710, a plating layer that may be excellent in adhesion to the metal substrate 710 and that is disposed in the middle among plating layers 740 may include a metal, such as Cu-Sn, Cu-Sn-Zn, Ni, Ni alloy, to be colored and/or glossy, and a plating layer that may be excellent in wear resistance and that is disposed at an end of the plating layers 740 may include a noble metal (e.g., Cr, Au, and Pt) to achieve a high appearance quality. According to various embodiments, the plating layer 740 may include at least three plating layers.

According to various embodiments, the deposition layer (not shown) may include at least one of Al, Ti, Cr, Zr, Au, Cu, Si, Ru, Rh, Pt, W, Pd, oxides, nitrides, and carbides thereof. According to various embodiments, the deposition layer may include a plurality of deposition layers. According to various embodiments, each of the plurality of deposition layers may include at least one of Al, Ti, Cr, Zr, Au, Cu, Si, Ru, Rh, Pt, W, Pd, oxides, nitrides, and carbides thereof.

According to various embodiments, the deposition layer may be formed on the plating layer 740, and the deposition layer may secure an adhesion to the plating layer 740 and may be excellent in corrosion resistance, hardness, wear resistance, and decorativeness. According to various embodiments, the deposition layer may exhibit various appearance qualities such as a gloss, texture, and surface shape of the metal substrate 710 and/or the plating layer 740. According to various embodiments, the deposition layer may include a plurality of deposition layers, and the respective deposition layers may have different purposes. For example, a deposition layer formed on the plating layer 740 may secure the adhesion to the plating layer 740 and may be excellent in corrosion resistance, a deposition layer disposed in the middle among the deposition layers may be excellent in hardness and wear resistance, and a deposition layer disposed at an end of the deposition layers may secure decorativeness and wear resistance. According to various embodiments, the deposition layer may include at least three deposition layers.

According to various embodiments, the plating layer 740 may have a thickness of 0.5 µm to 500 µm. According to various embodiments, the deposition layer may have a thickness of 0.1 µm to 50 µm. According to various embodiments, a ratio between the thickness of the plating layer 740 and the thickness of the deposition layer may be in a range of 5 : 1 to 100 : 1, and the deposition layer may desirably be thinner than the plating layer 740. According to various embodiments, the thickness of the plating layer 740 may be 5 times or less, 10 times or less, 15 times or less, 20 times or less, 25 times or less, 30 times or less, 35 times or less, 40 times or less, 45 times or less, 50 times or less, 55 times or less, 60 times or less, 65 times or less, 70 times or less, 75 times or less, 80 times or less, 85 times or less, 90 times or less, 95 times or less, or 100 times or less the thickness of the deposition layer.

According to various embodiments, a plastic injection part (e.g., the plastic injection part 720) may be formed in a hollow structure.

According to various embodiments, the plastic injection part (e.g., the plastic injection part 720) may include at least one of PC, ABS, PPS, PI, POM, PPO, PBT, PEEK, PAEK, PA, and PPA.

According to various embodiments, the plastic injection part (e.g., the plastic injection part 720) may further include at least one inorganic material among a glass fiber, a carbon fiber, and talc.

According to various embodiments, a plating layer (e.g., the plating layer 740 of FIG. 7) may include a plurality of plating layers, each including at least one of Cu, Ni, Cr, Zn, Sn, Cu-Sn, Cu-Sn-Zn, Au, and Pt, and a deposition layer may include a plurality of deposition layers, each including at least one of Al, Ti, Cr, Zr, Au, Cu, Si, Ru, Rh, Pt, W, Pd, oxides, nitrides, and carbides thereof.

According to various embodiments, a ratio between a thickness of the plating layer (e.g., the plating layer 740 of FIG. 7) and a thickness of the deposition layer may be in a range of 5 : 1 to 100 : 1.

According to various embodiments, an electronic device including an electronic device housing may be provided. According to various embodiments, the electronic device housing may include a metal substrate (e.g., the metal substrate 510 of FIG. 5, and the metal substrate 610 of FIG. 6), a plastic injection part (e.g., the plastic injection part 420 of FIG. 4, the plastic injection part 520 of FIG. 5, and the plastic injection part 620 of FIG. 6) formed on a first area of a surface of the metal substrate, an oxide film layer (e.g., the oxide film layer 430 of FIG. 4, the oxide film layer 530 of FIG. 5, and the oxide film layer 630 of FIG. 6) formed on a second area of the surface of the metal substrate, and a plating layer (e.g., the plating layer 440 of FIG. 4, the plating layer 540 of FIG. 5, and the plating layer 640 of FIG. 6) formed on a third area of the surface of the metal substrate. According to various embodiments, a deposition layer may be formed on the plating layer (e.g., the plating layer 440 of FIG. 4, the plating layer 540 of FIG. 5, and the plating layer 640 of FIG. 6).

According to various embodiments, the plastic injection part (e.g., the plastic injection part 420 of FIG. 4, the plastic injection part 520 of FIG. 5, and the plastic injection part 620 of FIG. 6) may be formed on at least a portion of the surface of the metal substrate (e.g., the metal substrate 510 of FIG. 5, and the metal substrate 610 of FIG. 6). For example, the plastic injection part (e.g., the plastic injection part 420 of FIG. 4, the plastic injection part 520 of FIG. 5, and the plastic injection part 620 of FIG. 6) may be formed on the first area of the metal substrate (e.g., the metal substrate 510 of FIG. 5, and the metal substrate 610 of FIG. 6). Here, the first area may be a collection of areas including two or more areas separately disposed.

According to various embodiments, the oxide film layer (e.g., the oxide film layer 430 of FIG. 4, the oxide film layer 530 of FIG. 5, and the oxide film layer 630 of FIG. 6) may be formed on the second area of the surface of the metal substrate (e.g., the metal substrate 510 of FIG. 5, and the metal substrate 610 of FIG. 6), and a plating layer may be formed on the third area of the surface of the metal substrate (e.g., the metal substrate 510 of FIG. 5, and the metal substrate 610 of FIG. 6). According to various embodiments, the second area and the third area may be portions of the surface of the metal substrate (e.g., the metal substrate 510 of FIG. 5, and the metal substrate 610 of FIG. 6) spaced apart from each other with the first area therebetween, and accordingly, the oxide film layer (e.g., the oxide film layer 430 of FIG. 4, the oxide film layer 530 of FIG. 5, and the oxide film layer 630 of FIG. 6) and plating layer (e.g., the plating layer 440 of FIG. 4, the plating layer 540 of FIG. 5, and the plating layer 640 of FIG. 6) may be formed to be spaced apart from each other.

According to various embodiments, the plastic injection part (e.g., the plastic injection part 420 of FIG. 4, the plastic injection part 520 of FIG. 5, and the plastic injection part 620 of FIG. 6) may be formed in a hollow structure. According to various embodiments, the plastic injection part (e.g., the plastic injection part 420 of FIG. 4, the plastic injection part 520 of FIG. 5, and the plastic injection part 620 of FIG. 6) may form a band shape, such as "∘" or "□" but the shape of the plastic injection part (e.g., the plastic injection part 420 of FIG. 4, the plastic injection part 520 of FIG. 5, and the plastic injection part 620 of FIG. 6), such as "∘" or "□," is merely an example and it is obvious to one of ordinary skill in the art that various hollow structures may be formed. According to various embodiments, the plating layer (e.g., the plating layer 440 of FIG. 4, the plating layer 540 of FIG. 5, and the plating layer 640 of FIG. 6) and the deposition layer may be formed on a surface of an electronic device housing (e.g., the electronic device housing 400 of FIG. 4, the electronic device housing 500 of FIG. 5, and the electronic device housing 600 of FIG. 6) that relatively forms an exterior of the electronic device, the oxide film layer (e.g., the oxide film layer 430 of FIG. 4, the oxide film layer 530 of FIG. 5, and the oxide film layer 630 of FIG. 6) may be formed on a surface of the electronic device housing that relatively forms an interior of the electronic device, and the plastic injection part (e.g., the plastic injection part 420 of FIG. 4, the plastic injection part 520 of FIG. 5, and the plastic injection part 620 of FIG. 6) may be formed between the oxide film layer (e.g., the oxide film layer 430 of FIG. 4, the oxide film layer 530 of FIG. 5, and the oxide film layer 630 of FIG. 6) and the plating layer (e.g., the plating layer 440 of FIG. 4, the plating layer 540 of FIG. 5, and the plating layer 640 of FIG. 6) and/or the deposition layer, to substantially separate the oxide film layer (e.g., the oxide film layer 430 of FIG. 4, the oxide film layer 530 of FIG. 5, and the oxide film layer 630 of FIG. 6) from the plating layer (e.g., the plating layer 440 of FIG. 4, the plating layer 540 of FIG. 5, and the plating layer 640 of FIG. 6) and/or the deposition layer, and to substantially prevent a contact between the oxide film layer and the plating layer and/or the deposition layer.

According to various embodiments, an electronic device housing may be applied to a support member of an electronic device. According to various embodiments, the electronic device housing may be applied to a battery cover (the PCB 340) or a support member (e.g., the first support member 311 and the second support member 360 of FIG. 3) as a support member of an electronic device. According to various embodiments, an electronic device may include, but is not limited to, a portable electronic device, a wearable electronic device, and a laptop.

According to various embodiments, a plastic injection part may be formed in a hollow structure.

According to various embodiments, an electronic device housing may be applied to a support member of an electronic device.

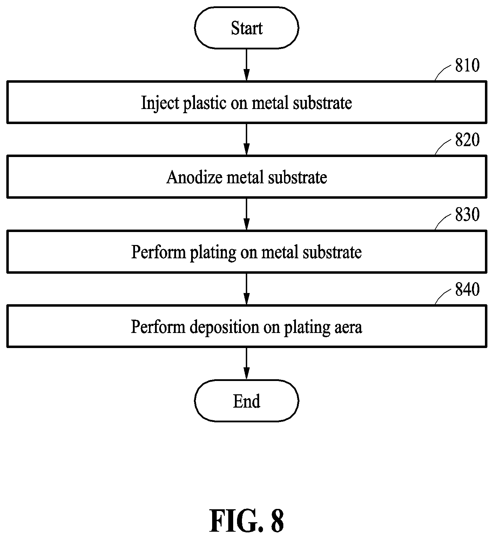

FIG. 8 is a flowchart illustrating a process of an electronic device housing according to various embodiments.

According to various embodiments, a method of manufacturing an electronic device housing may include the following steps:
(a) step 810 of injecting a plastic on a metal substrate,
(b) step 820 of anodizing the metal substrate,
(c) step 830 of performing plating on the metal substrate,
(d) step 840 of performing a deposition on a plating area.

According to various embodiments, (a) step 810 of injecting the plastic may be performed by injecting a plastic between areas on which subsequent steps ((b) step 820 of anodizing the metal substrate, and (c) step 830 of performing the plating), based on the areas, to form a plastic injection part. According to various embodiments, the injected plastic may be a non-conductive engineering plastic and may include at least one of polycarbonate (PC), acrylonitrile butadiene styrene (ABS), polyphenylene sulfide (PPS), polyimide (PI), polyoxymethylene (POM), polyphenylene oxide (PPO), polybutylene terephthalate (PBT), polyether ether ketone (PEEK), polyaryletherketone (PAEK), polyamide (PA), and polyphthalamide (PPA).

According to various embodiments, through (b) step 820 of anodizing the metal substrate, a non-conductive oxide film may be formed on the metal substrate through an anodizing process. According to various embodiments, since an oxide film based on the anodizing does not have conductivity, plating may not be performed on an area in which the oxide film is formed. According to various embodiments, (b) step 820 of anodizing the metal substrate may be performed by immersing the metal substrate in an anodizing solution containing sulfuric acid. Here, the anodizing solution may further include at least one of hydrochloric acid, phosphoric acid, nitric acid, oxalic acid, chromic acid, sulfamic acid, maronic acid, sodium hydroxide, sodium sulfate, ammonium bifluoride, hydrofluoric acid, sodium fluoride, potassium fluoride, ammonium fluoride, and triazine thiol. Subsequently, through a sealing treatment, contamination of the oxide film may be prevented, a durability of a film may be improved, and color may be realized.

According to various embodiments, after (b) step 820 of anodizing the metal substrate, a step of forming a coating layer on the oxide film may be performed. According to various embodiments, the step of forming the coating layer may be performed to protect the oxide film, and coating may be performed using a non-conductive organic material, such as electrodeposition, painting, or photoresist. According to various embodiments, in a coating step, coating may be performed using an organic material and drying may be performed at 100°C or less, to form a coating layer in which cracking of the oxide film is suppressed.

According to various embodiments, in (c) step 830 of performing the plating, a plating layer may be formed on a surface of the metal substrate on which a plastic injection part and an oxide film are not formed. According to various embodiments, prior to (c) step 830 of performing the plating, a step of processing an exterior surface may be performed. According to various embodiments, the step of processing the exterior surface may be performed to form a shape by performing computerized numerical control (CNC) processing on a surface exposed to the exterior and to remove the oxide film.

According to various embodiments, a plating layer may be formed by additionally removing an oxide film naturally generated through a pretreatment for plating. Here, the pretreatment for plating may be performed by immersion in an etching solution including at least one of caustic soda and phosphoric acid for 10 to 60 seconds at room temperature, and immersion in an acid solution including at least one of sulfuric acid and fluoride, to remove smut. Subsequently, to prevent natural oxidation of the metal substrate, a zinc protective film may be temporarily formed through a treatment with zincate.

According to various embodiments, based on (c) step 830 of performing the plating, at least one metal among Cu, Ni, Cr, Zn, Sn, Cu-Sn, Cu-Sn-Zn, Au, and Pt may be plated, to form a plating layer on the metal substrate. According to various embodiments, the plating layer may include a plurality of plating layers through multiple plating steps. According to various embodiments, the plating layer may include at least three plating layers, and for example, Cu plating, Ni plating, and Cr plating may be sequentially performed on a surface of the metal substrate. However, it is obvious to one of ordinary skill that metals that may be plated are not limited thereto.

According to various embodiments, in (d) step 840 of performing the deposition on the plating area, a deposition layer that realizes color may be formed on an exterior of the metal substrate. According to various embodiments, the deposition layer may include at least one of Al, Ti, Cr, Zr, Au, Cu, Si, Ru, Rh, Pt, W, Pd, oxides, nitrides, and carbides thereof. According to various embodiments, the deposition layer may include a plurality of deposition layers through multiple deposition steps. According to various embodiments, the deposition layer may include at least three deposition layers. After (d) step of performing the deposition, a deposition film formed on a segmentation portion such as a resin slit between metal substrates may be removed to ensure performance of an antenna.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that various embodiments of the present disclosure and the terms used therein are not intended to limit the technological features set forth herein to particular embodiments and include various changes, equivalents, or replacements for a corresponding embodiment within the scope of the present invention defined by the appended set of claims. In connection with the description of the drawings, like reference numerals may be used for similar or related components. It is to be understood that a singular form of a noun corresponding to an item may include one or more of the things, unless the relevant context clearly indicates otherwise. Terms such as "1^{st}," "2^{nd}," or "first" or "second" may simply be used to distinguish the component from other components in question, and may refer to components in other aspects (e.g., importance or order) is not limited. It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

## Claims

1. An electronic device housing (400, 500, 600, 700), comprising:
a metal substrate (510, 610, 710);
a plastic injection part (420, 520, 620, 720) formed by injecting a plastic on a first area (521, 621, 721) of a surface of the metal substrate (510, 610, 710);
an oxide film layer (430, 530, 630, 730) formed on a second area (531, 631, 731) of the surface of the metal substrate (510, 610, 710); and
a plating layer (440, 540, 640, 740) formed on a third area (541, 641, 741) of the surface of the metal substrate (510, 610, 710), wherein the oxide film layer (430, 530, 630, 730) and the plating layer (440, 540, 640, 740) are formed to be spaced apart from each other by the plastic injection part (420, 520, 620, 720) formed therebetween.

2. The electronic device housing (400, 500, 600, 700) of claim 1, wherein the plastic injection part (420, 520, 620, 720) is formed in a hollow structure.

3. The electronic device housing (400, 500, 600, 700) of claim 1, wherein
the plating layer (440, 540, 640, 740) comprises a plurality of plating layers, and
each of the plurality of plating layer (440, 540, 640, 740)s comprises at least one of Cu, Ni, Cr, Zn, Sn, Cu-Sn, Cu-Sn-Zn, Au, and Pt.

4. The electronic device housing (400, 500, 600, 700) of claim 1, further comprising:
a deposition layer formed on the plating layer (440, 540, 640, 740),
wherein the deposition layer comprises a plurality of deposition layers, and
each of the plurality of deposition layers comprises at least one of Al, Ti, Cr, Zr, Au, Cu, Si, Ru, Rh, Pt, W, Pd, oxides, nitrides, and carbides thereof.

5. The electronic device housing (400, 500, 600, 700) of claim 4, wherein a ratio between a thickness of the plating layer (440, 540, 640, 740) and a thickness of the deposition layer is in a range of 5 : 1 to 100 : 1.

6. The electronic device housing (400, 500, 600, 700) of claim 1, wherein the plastic injection part (420, 520, 620, 720) comprises at least one of PC, ABS, PPS, PI, POM, PPO, PBT, PEEK, PAEK, PA, and PPA.

7. The electronic device housing (400, 500, 600, 700) of claim 6, wherein the plastic injection part (420, 520, 620, 720) further comprises at least one inorganic material among a glass fiber, a carbon fiber, and talc.

8. The electronic device housing (400, 500, 600, 700) of claim 1, wherein the metal substrate (510, 610, 710) comprises at least one of Al, Ti, Mg, and Zn.

9. The electronic device housing (700) of claim 1,
wherein the metal substrate (710) is formed by bonding a first metal portion (711) and a second metal portion (712);
wherein the first area (521, 621, 721) comprises at least a portion of a bounding portion between the first metal portion (711) and the second metal portion (712), , and
wherein each of the first metal portion (711) and the second metal portion (712) comprises at least one of Al, Ti, Mg, and Zn.

10. The electronic device housing (700) of claim 9, wherein the plastic injection part (720) is formed in a hollow structure.

11. The electronic device housing (700) of claim 9, comprising:
a deposition layer formed on the plating layer (740),
wherein the deposition layer comprises a plurality of deposition layers, each comprising at least one of Al, Ti, Cr, Zr, Au, Cu, Si, Ru, Rh, Pt, W, Pd, oxides, nitrides, and carbides thereof.

12. The electronic device housing (700) of claim 10, wherein the plastic injection part (720) further comprises at least one inorganic material among a glass fiber, a carbon fiber, and talc.

13. The electronic device housing (700) of claim 9, wherein the plating layer (740) comprises a plurality of plating layers, each comprising at least one of Cu, Ni, Cr, Zn, Sn, Cu-Sn, Cu-Sn-Zn, Au, and Pt.

14. The electronic device housing (700) of claim 11, wherein a ratio between a thickness of the plating layer (740) and a thickness of the deposition layer is in a range of 5 : 1 to 100 : 1.

15. An electronic device (100) comprising an electronic device housing (400, 500, 600, 700) according to any one of the preceding claims.

## Patentansprüche

1. Gehäuse (400, 500, 600, 700) einer elektronischen Vorrichtung, umfassend:
ein Metallsubstrat (510, 610, 710);
ein Kunststoffeinspritzteil (420, 520, 620, 720), ausgebildet durch Einspritzen eines Kunststoffs auf einen ersten Bereich (521, 621, 721) einer Fläche des Metallsubstrats (510, 610, 710);
eine Oxidfilmschicht (430, 530, 630, 730), die auf einem zweiten Bereich (531, 631, 731) der Fläche des Metallsubstrats (510, 610, 710) ausgebildet ist; und
eine auf einem dritten Bereich (541, 641, 741) der Fläche des Metallsubstrats (510, 610, 710) ausgebildete Plattierungsschicht (440, 540, 640, 740), wobei die Oxidfilmschicht (430, 530, 630, 730) und die Plattierungsschicht (440, 540, 640, 740) so ausgebildet sind, dass sie voneinander beabstandet sind durch den dazwischen ausgebildeten Kunststoffeinspritzteil (420, 520, 620, 720).

2. Gehäuse (400, 500, 600, 700) einer elektronischen Vorrichtung nach Anspruch 1, wobei das Kunststoffeinspritzteil (420, 520, 620, 720) in einer Hohlstruktur ausgebildet ist.

3. Gehäuse (400, 500, 600, 700) einer elektronischen Vorrichtung nach Anspruch 1, wobei
die Plattierungsschicht (440, 540, 640, 740) eine Vielzahl von Plattierungsschichten umfasst, und
jede der Vielzahl von Plattierungsschichten (440, 540, 640, 740) mindestens eines von Cu, Ni, Cr, Zn, Sn, Cu-Sn, Cu-Sn-Zn, Au und Pt umfasst.

4. Gehäuse (400, 500, 600, 700) einer elektronischen Vorrichtung nach Anspruch 1, ferner umfassend:
eine auf der Plattierungsschicht (440, 540, 640, 740) ausgebildete Abscheidungsschicht,
wobei die Abscheidungsschicht eine Vielzahl von Abscheidungsschichten umfasst, und
jede der Vielzahl von Abscheidungsschichten mindestens eines von Al, Ti, Cr, Zr, Au, Cu, Si, Ru, Rh, Pt, W, Pd, deren Oxide, Nitride und Carbide umfasst.

5. Gehäuse (400, 500, 600, 700) einer elektronischen Vorrichtung nach Anspruch 4, wobei ein Verhältnis zwischen einer Dicke der Plattierungsschicht (440, 540, 640, 740) und einer Dicke der Abscheidungsschicht in einem Bereich von 5:1 bis 100:1 liegt.

6. Gehäuse (400, 500, 600, 700) einer elektronischen Vorrichtung nach Anspruch 1, wobei das Kunststoffeinspritzteil (420, 520, 620, 720) mindestens eines von PC, ABS, PPS, Pl, POM, PPO, PBT, PEEK, PAEK, PA und PPA umfasst.

7. Gehäuse (400, 500, 600, 700) einer elektronischen Vorrichtung nach Anspruch 6, wobei das Kunststoffeinspritzteil (420, 520, 620, 720) ferner mindestens ein anorganisches Material aus einer Glasfaser, einer Kohlenstofffaser und Talk umfasst.

8. Gehäuse (400, 500, 600, 700) einer elektronischen Vorrichtung nach Anspruch 1, wobei das Metallsubstrat (510, 610, 710) mindestens eines von Al, Ti, Mg und Zn umfasst.

9. Gehäuse (700) einer elektronischen Vorrichtung nach Anspruch 1,
wobei das Metallsubstrat (710) durch Verbinden eines ersten Metallabschnitts (711) und eines zweiten Metallabschnitts (712) ausgebildet ist;
wobei der erste Bereich (521, 621, 721) zumindest einen Teil eines Begrenzungsabschnitts zwischen dem ersten Metallabschnitt (711) und dem zweiten Metallabschnitt (712) umfasst, und
wobei jeder des ersten Metallabschnitts (711) und des zweiten Metallabschnitts (712) mindestens eines von Al, Ti, Mg und Zn umfasst.

10. Gehäuse (700) einer elektronischen Vorrichtung nach Anspruch 9, wobei das Kunststoffeinspritzteil (720) in einer Hohlstruktur ausgebildet ist.

11. Gehäuse (700) einer elektronischen Vorrichtung nach Anspruch 9, umfassend:
eine auf der Plattierungsschicht (740) ausgebildete Abscheidungsschicht,
wobei die Abscheidungsschicht eine Vielzahl von Abscheidungsschichten umfasst, von denen jede mindestens eines von Al, Ti, Cr, Zr, Au, Cu, Si, Ru, Rh, Pt, W, Pd, deren Oxide, Nitride und Carbide umfasst.

12. Gehäuse (700) einer elektronischen Vorrichtung nach Anspruch 10, wobei das Kunststoffeinspritzteil (720) ferner mindestens ein anorganisches Material aus einer Glasfaser, einer Kohlenstofffaser und Talk umfasst.

13. Gehäuse (700) einer elektronischen Vorrichtung nach Anspruch 9, wobei die Plattierungsschicht (740) eine Vielzahl von Plattierungsschichten umfasst, von denen jede mindestens eines von Cu, Ni, Cr, Zn, Sn, Cu-Sn, Cu-Sn-Zn, Au und Pt umfasst.

14. Gehäuse (700) einer elektronischen Vorrichtung nach Anspruch 11, wobei ein Verhältnis zwischen einer Dicke der Plattierungsschicht (740) und einer Dicke der Abscheidungsschicht in einem Bereich von 5:1 bis 100:1 liegt.

15. Elektronische Vorrichtung (100), umfassend ein Gehäuse (400, 500, 600, 700) einer elektronischen Vorrichtung nach einem der vorhergehenden Ansprüche.

## Revendications

1. Boîtier (400, 500, 600, 700) de dispositif électronique, comprenant :
un substrat métallique (510, 610, 710) ;
une partie d'injection plastique (420, 520, 620, 720) formée par injection d'un plastique sur une première zone (521, 621, 721) d'une surface du substrat métallique (510, 610, 710) ;
une couche de film d'oxyde (430, 530, 630, 730) formée sur une seconde zone (531, 631, 731) de la surface du substrat métallique (510, 610, 710) ; et
une couche de placage (440, 540, 640, 740) formée sur une troisième zone (541, 641, 741) de la surface du substrat métallique (510, 610, 710), la couche de film d'oxyde (430, 530, 630, 730) et la couche de placage (440, 540, 640, 740) étant formées pour être espacées l'une de l'autre par la partie d'injection plastique (420, 520, 620, 720) formée entre elles.

2. Boîtier (400, 500, 600, 700) de dispositif électronique de la revendication 1, dans lequel la partie d'injection plastique (420, 520, 620, 720) est formée dans une structure creuse.

3. Boîtier (400, 500, 600, 700) de dispositif électronique de la revendication 1, dans lequel
la couche de placage (440, 540, 640, 740) comprend une pluralité de couches de placage, et
chacune de la pluralité de couches de placage (440, 540, 640, 740) comprend au moins l'un de Cu, Ni, Cr, Zn, Sn, Cu-Sn, Cu-Sn-Zn, Au et Pt.

4. Boîtier (400, 500, 600, 700) de dispositif électronique de la revendication 1, comprenant en outre :
une couche de dépôt formée sur la couche de placage (440, 540, 640, 740),
dans lequel la couche de dépôt comprend une pluralité de couches de dépôt, et
chacune de la pluralité de couches de dépôt comprend au moins l'un d'Al, Ti, Cr, Zr, Au, Cu, Si, Ru, Rh, Pt, W, Pd, leurs oxydes, nitrures et carbures.

5. Boîtier (400, 500, 600, 700) de dispositif électronique de la revendication 4, dans lequel un rapport entre une épaisseur de la couche de placage (440, 540, 640, 740) et une épaisseur de la couche de dépôt est compris entre 5:1 et 100:1.

6. Boîtier (400, 500, 600, 700) de dispositif électronique de la revendication 1, dans lequel la partie d'injection plastique (420, 520, 620, 720) comprend au moins l'un de PC, ABS, PPS, Pl, POM, PPO, PBT, PEEK, PAEK, PA, et PPA.

7. Boîtier (400, 500, 600, 700) de dispositif électronique de la revendication 6, dans lequel la partie d'injection plastique (420, 520, 620, 720) comprend en outre au moins un matériau inorganique parmi une fibre de verre, une fibre de carbone et du talc.

8. Boîtier (400, 500, 600, 700) de dispositif électronique de la revendication 1, dans lequel le substrat métallique (510, 610, 710) comprend au moins l'un d'Al, Ti, Mg et Zn.

9. Boîtier (700) de dispositif électronique de la revendication 1,
dans lequel le substrat métallique (710) est formé par le collage d'une première partie métallique (711) et d'une seconde partie métallique (712) ;
dans lequel la première zone (521, 621, 721) comprend au moins une partie d'une partie de délimitation entre la première partie métallique (711) et la seconde partie métallique (712), et
dans lequel chacune de la première partie métallique (711) et de la seconde partie métallique (712) comprend au moins l'un d'Al, Ti, Mg et Zn.

10. Boîtier (700) de dispositif électronique de la revendication 9, dans lequel la partie d'injection plastique (720) est formée dans une structure creuse.

11. Boîtier (700) de dispositif électronique de la revendication 9, comprenant :
une couche de dépôt formée sur la couche de placage (740),
dans lequel la couche de dépôt comprend une pluralité de couches de dépôt, chacune comprenant au moins l'un d'Al, Ti, Cr, Zr, Au, Cu, Si, Ru, Rh, Pt, W, Pd, leurs oxydes, nitrures et carbures.

12. Boîtier (700) de dispositif électronique de la revendication 10, dans lequel la partie d'injection plastique (720) comprend en outre au moins un matériau inorganique parmi une fibre de verre, une fibre de carbone et du talc.

13. Boîtier (700) de dispositif électronique de la revendication 9, dans lequel la couche de placage (740) comprend une pluralité de couches de placage, chacune comprenant au moins l'un de Cu, Ni, Cr, Zn, Sn, Cu-Sn, Cu-Sn-Zn, Au et Pt.

14. Boîtier (700) de dispositif électronique de la revendication 11, dans lequel un rapport entre une épaisseur de la couche de placage (740) et une épaisseur de la couche de dépôt est compris entre 5:1 et 100:1.

15. Dispositif électronique (100) comprenant un boîtier (400, 500, 600, 700) de dispositif électronique de l'une quelconque des revendications précédentes.
